# EUROPÄISCHE PATENTSCHRIFT

(11) **EP 1 019 972 B1**
(45) Veröffentlichungstag und Bekanntmachung des Hinweises auf die Patenterteilung: **15.11.2006**
(21) Anmeldenummer: 98954215.4
(22) Anmeldetag: 22.09.1998
(51) Int. Cl.: H01L 41/09

(54) **PIEZOELEKTRISCHES ELEMENT**
PIEZO-ELECTRIC ELEMENT
ELEMENT PIEZO-ELECTRIQUE

(30) Priorität: 30.09.1997 DE 19743332
(43) Veröffentlichungstag der Anmeldung: 19.07.2000
(73) Patentinhaber: Argillon GmbH, 96257 Redwitz (DE)
(72) Erfinder: RIEDEL, Michael, D-96472 Rödental (DE)
(74) Vertreter: Tergau & Pohl Patentanwälte
(86) Internationale Anmeldenummer: PCT/DE1998/002810
(87) Internationale Veröffentlichungsnummer: WO 1999/017383

(56) Entgegenhaltungen:
- EP-A- 0 591 885
- DE-A- 19 520 796
- US-A- 4 363 993
- US-A- 5 404 067
- PATENT ABSTRACTS OF JAPAN vol. 010, no. 016 (E-375), 22. Januar 1986 & JP 60 178677 A (NIPPON DENSHIN DENWA KOSHA), 12. September 1985

## Beschreibung

Die Erfindung bezieht sich auf ein piezoelektrisches Element mit einem ersten und einem zweiten Stapel aus einer Mehrzahl von piezoelektrischen Keramikschichten und mit einer zwischen dem ersten und dem zweiten Stapel angeordneten Zwischenschicht, wobei in jedem Stapel zwischen den jeweiligen Keramikschichten und an der jeweiligen Außenseite der den Stapel begrenzenden Keramikschichten Elektroden angeordnet sind.

Ein derartiges piezoelektrisches Element ist aus der DE 35 18 055 A1 und der DE 34 34 726 C2 bekannt. Zur Betätigung des piezoelektrischen Elements werden die Elektroden derart mit einer Spannung beaufschlagt, daß die piezoelektrischen Keramikschichten des ersten Stapels jeweils expandieren, während die piezoelektrischen Keramikschichten des zweiten Stapels jeweils kontrahieren oder umgekehrt. Dies führt zu einer Verbiegung des piezoelektrischen Elements, die zur Betätigung eines mechanischen oder elektrischen Schalters ausgenutzt werden kann. Die zwischen den beiden Stapeln angeordnete Zwischenschicht ist ebenfalls eine Keramikschicht, die jedoch selbst keine aktive Bewegung ausführt. Hierzu ist die Keramik der Zwischenschicht entweder nicht polarisiert und folglich nicht piezoelektrisch aktiv, oder aber sie wird bei Ansteuerung des piezoelektrischen Elements keinem elektrischen Feld ausgesetzt. Die Zwischenschicht dient zum Ausgleich der entgegengesetzten Bewegungen der beiden Stapel und erhöht damit die Lebensdauer des piezoelektrischen Elements.

Ein piezoelektrisches Element, welches aus einer Vielzahl von aufeinandergestapelten Keramikschichten besteht, wird auch als ein sogenanntes multimorphes piezoelektrisches Element bezeichnet. Im Gegensatz hierzu wird ein piezoelektrisches Element, bei welchem die Stapel durch eine einzige zusammenhängende Keramikschicht ersetzt sind, als ein bimorphes oder als ein trimorphes piezoelektrisches Element bezeichnet, je nachdem, ob zwischen den beiden Keramikschichten eine Zwischenschicht angeordnet ist bzw. nicht. Ein multimorphes piezoelektrisches Element bietet gegenüber einem bimorphen oder trimorphen piezoelektrischen Element den Vorteil, daß die gleiche mechanische Energie bereits bei einer niedriger angelegten Spannung zur Verfügung gestellt wird. Dies ist darin begründet, daß die einzelnen Keramikschichten eines multimorphen piezoelektrischen Elements eine wesentlich geringere Dicke aufweisen als die Keramikschichten eines vergleichbaren bi- oder trimorphen piezoelektrischen Elements, so daß sich bei gleicher Spannung gemäß E = U/d, wobei E das elektrische Feld, U die angelegte Spannung und d die Dicke der Keramikschicht angibt, ein höheres elektrisches Feld einstellt.

Aus der JP 60-178677 A2 ist ferner ein piezoelektrisches multimorphes Element bekannt, wobei sich das Material der Zwischenschicht von dem Material der Keramikschichten unterscheidet.

Nachteiligerweise zeigt jedoch ein multimorphes piezoelektrisches Element aufgrund der vielen, vergleichsweise dünnen aufeinandergestapelten keramischen Einzelschichten eine hohe Bruchempfindlichkeit und eine vergleichsweise geringe mechanische Stabilität. So kommt es unter Last häufig zu einem Driften der einzelnen Schichten gegeneinander. Des weiteren zeigt ein multimorphes piezoelektrisches Element gegenüber einem bi- oder trimorphen piezoelektrischen Element einen geringeren Wirkungsgrad. Auch ist seine Herstellung mit höheren Kosten verbunden.

Aus den genannten Gründen wird bislang in technischen Anwendungen einem bi- oder trimorphen piezoelektrischen Element der Vorzug gegeben, obgleich sich ein multimorphes piezoelektrisches Element mit einer geringeren Spannung betreiben läßt.Aus der US 5,404,067 sowie der US 4,363,993 sind jeweils trimorphe piezoelektrische Elemente mit einer Zwischenschicht aus einem Faserverbundwerkstoff bekannt. Technische Anwendungen für ein piezoelektrisches Element sind z.B. als piezoelektrischer Druckkopf für einen Tintenstrahldrucker, als Schallaufnehmer oder -erzeuger für ein Mikrophon bzw. einen Lautsprecher, als Sensor für die Beschleunigungs- oder Druckmessung, als Meßwertaufnehmer für Gaszähler und insbesondere als Biegewandler, beispielsweise als Stellelement in Braille-Zeilen, in Lesegeräten für Blinde, in Textilmaschinen, in Pneumatikventilen, in schreibenden Meßgeräten oder in berührungslosen Oberflächen-Meßinstrumenten usw. Dabei würde eine niedrige Betriebsspannung den Einsatz des piezoelektrischen Elements auch an explosionsgefährdeten Orten, wie beispielsweise in der chemischen Industrie oder im Bergbau, ermöglichen.

Aufgabe der Erfindung ist es, ein multimorphes piezoelektrisches Element anzugeben, welches gegenüber einem bi- oder trimorphen piezoelektrischen Element den Vorteil einer niedrigeren Betriebsspannung aufweist, und mit dem insbesondere die genannten Nachteile des Standes der Technik überwunden werden.

Zur Lösung dieser Aufgabe wird ein piezoelektrisches Element mit einem ersten und einem zweiten Stapel aus einer Mehrzahl von piezoelektrischen Keramikschichten und mit einer zwischen dem ersten und dem zweiten Stapel angeordneten Zwischenschicht angegeben, wobei in jedem Stapel zwischen den jeweiligen Keramikschichten und an der jeweiligen Außenseite der den Stapel begrenzenden Keramikschichten Elektroden angeordnet sind, und wobei sich das Material der Zwischenschicht von dem Material der Keramikschichten unterscheidet, wobei erfindungsgemäß die Zwischenschicht in Form eines Tragkörpers aus einem Faserverbundwerkstoff oder aus Glas ausgebildet ist.

Dadurch, daß die Zwischenschicht als ein Tragkörper aus einem Faserverbundwerkstoff oder aus Glas aufgebaut ist, wird ein multimorphes piezoelektrisches Element aus einem Materialverbund geschaffen, welches gegenüber einem, abgesehen von den Elektroden, rein keramischen multimorphen piezoelektrischen Element eine wesentlich höhere mechanische Stabilität aufweist. Eine derartige Zwischenschicht dient nicht lediglich dem Ausgleich von Spannungen, sondern übernimmt zusätzlich eine tragende und stützende Funktion für das gesamte piezoelektrische Element.

Durch den Einsatz eines Tragkörpers aus einem Faserverbundwerkstoff oder aus Glas für ein multimorphes piezoelektrisches Element wird zusätzlich der Wirkungsgrad der Umwandlung von elektrischer in mechanischer Energie verbessert. Durch den Ersatz eines Teils des keramischen Materials eines multimorphen piezoelektrischen Elements durch einen derartigen Tragkörper wird die Bruchempfindlichkeit des piezoelektrischen Elements wesentlich verringert, was einen unschätzbaren Vorteil insbesondere beim Einbau oder beim Betrieb bietet. Daneben werden auf diese Weise Fertigungskosten eingespart, da piezokeramisches Material, insbesondere das Vielschicht-Material eines multimorphen piezoelektrischen Elements, vergleichsweise teuer ist.

Es wird durch die Erfindung ein multimorphes piezoelektrisches Element geschaffen, welches sich mit niedrigen Spannungen ansteuern läßt, einen hohen Wirkungsgrad besitzt, eine geringe Bruchempfindlichkeit bei einer gleichzeitig hohen mechanischen Stabilität aufweist und aufgrund des verbesserten Wirkungsgrades mit weniger des vergleichsweise teueren keramischen Multischichten-Materials auskommt, als ein vergleichbares rein keramisches multimorphes piezoelektrisches Element. Mit keramischem Vielschicht-Material sei dabei dasjenige Material bezeichnet, welches sich aus übereinandergestapelten Keramikschichten (polarisiert oder nicht) und dazwischen angeordneten Elektroden beispielsweise in Form einer Metallisierung zusammensetzt.

Eine Einsparung an keramischem Vielschicht-Material bei gleichzeitiger Erhöhung der mechanischen Stabilität und des Wirkungsgrades des piezoelektrischen Elements läßt sich vorteilhafterweise dadurch erzielen, daß die Dicke des Tragkörpers größer gewählt ist als die Dicke einer einzelnen Keramikschicht in einem Stapel oder in dem keramischen Vielschicht-Material. Dabei hat es sich insbesondere gezeigt, daß das piezoelektrische Element hervorragende Eigenschaften aufweist, wenn die Dicke des Tragkörpers im wesentlichen gleich der jeweiligen Dicke eines Stapels ist. Damit lassen sich insbesondere gegenüber einem rein keramischen multimorphen piezoelektrischen Element bis zu einem Drittel der Materialkosten für das keramische Vielschicht-Material einsparen.

Bei der Herstellung wird der Faserverbundwerkstoff in Form eines sogenannten Prepregs (ein noch nicht ausgehärteter weicher vorimprägnierter Rohling) verwendet. Zur Herstellung werden einfach der erste Stapel, der Tragkörper in Form des Prepregs und der zweite Stapel lose aufeinandergelegt, anschließend unter Druck verpreßt und durch eine Wärmebehandlung unter Aushärtung des Prepregs miteinander verklebt.

In einer weiteren vorteilhaften Ausgestaltung der Erfindung ist der Faserverbundwerkstoff ein mit Kohle- oder Glasfaser verstärktes Epoxidharz. Dies erhöht die mechanische Stabilität und Bruchfestigkeit.

Falls der Tragkörper aus Glas besteht, werden die beiden Stapel aus piezoelektrischen Keramikschichten oder keramischem Vielschicht-Material durch einen geeigneten Kleber mit dem Tragkörper verbunden.

Um das piezoelektrische Element mit einer niedrigen Betriebsspannung und mit einem hohen Wirkungsgrad betreiben zu können, ist es zweckmäßig, wenn die Dicke der Keramikschichten jeweils zwischen 20 und 40 µm und die Dicke des Tragkörpers zwischen 100 und 1000 µm liegt. Bei derartigen Dicken der einzelnen Keramikschichten genügen Betriebsspannungen zwischen 20 und 80 Volt, um Feldstärken von größer als 1 kV/mm zu erzielen. Derartige Feldstärken sind notwendig, um bei Verwendung des piezoelektrischen Elements als ein Stell- oder Biegeelement eine hinreichend große Stell- bzw. Biegekraft zu erhalten.

Das multimorphe piezoelektrische Element kann nun prinzipiell in zwei Varianten angesteuert werden. Bei der ersten Variante sind alle Keramikschichten eines Stapels parallel zueinander und entlang der Stapelrichtung polarisiert. Dies geschieht beispielsweise durch Anlegen eines gerichteten, homogenen elektrischen Feldes von einigen kV/mm. Ein derartiges piezoelektrisches Element wird angesteuert, indem innerhalb eines Stapels von Elektrode zu Elektrode die anliegende Spannung jeweils um denselben Betrag ab- bzw. zunimmt. Auf diese Weise sieht jede einzelne piezoelektrische Keramikschicht eines Stapels das gleiche elektrische Feld, jedoch auf unterschiedlichem Niveau. Demnach führen alle angesteuerten piezoelektrischen Keramikschichten eines Stapels die gleiche Bewegung aus, d.h. entweder sie kontrahieren oder sie expandieren. Zur Verbiegung des piezoelektrischen Elements kann es nun vorgesehen sein, daß die Keramikschichten eines Stapels kontrahieren, während die Keramikschichten des anderen Stapels expandieren, oder aber es wird lediglich ein Stapel angesteuert, während die Keramikschichten des anderen Stapels keine Bewegung ausführen.

Letzteres hat den Vorteil, daß die piezoelektrischen Keramikschichten nicht entgegen ihrer Polarisationsrichtung mit einem elektrischen Feld beaufschlagt werden müssen. Bei einer Spannungsbeaufschlagung entgegen der Polarisationsrichtung kann nämlich nur eine Spannung bis maximal der Hälfte der Koerzitivfeldstärke angelegt werden, da ansonsten eine Depolarisation der piezoelektrischen Keramik auftritt, was mit einer Verringerung des piezoelektrischen Effekts verbunden ist. Bei einer derartigen Ansteuerung addieren sich jedoch die an einer einzelnen Keramikschicht anliegenden Spannungen entsprechend der Anzahl der Keramikschichten in einem Stapel zu einer nicht unerheblichen Gesamtspannung. Zudem muß jede einzelne Elektrode eines Stapels separat kontaktiert werden, da jede der Elektroden auf einem anderen Potential liegt.

Daher ist eher die zweite Variante der Ansteuerung vorzuziehen, wofür benachbarte Keramikschichten eines Stapel in jeweils entgegengesetzter Richtung, jedoch ebenfalls parallel zur Stapelrichtung, polarisiert sind. Zur Ansteuerung eines derartigen multimorphen piezoelektrischen Elements wird an die Elektroden benachbarter Keramikschichten eine Potentialdifferenz gleicher Höhe, jedoch mit unterschiedlichem Vorzeichen angelegt. Auf diese Weise werden benachbarte Keramikschichten mit einem elektrischen Feld gleicher Größe, jedoch mit unterschiedlicher Richtung beaufschlagt. In Stapelrichtung betrachtet, liegt daher jede zweite Elektrode auf gleichem Potential. Es ist daher zweckmäßig, die Elektroden jedes Stapels jeweils derart in eine erste und in eine zweite Gruppe elektrisch verbundener Elektroden aufzuteilen, daß benachbarte Elektroden jeweils der anderen Gruppe zugeordnet sind. Zur Ansteuerung wird dann die erste Gruppe elektrisch verbundener Elektroden an den einen Pol und die zweite Gruppe elektrisch verbundener Elektroden an den anderen Pol einer Spannungsquelle angeschlossen. Die Spannungsquelle braucht dabei nur eine relativ niedrige Spannung zu liefern, welche ausreicht, um entsprechend der geringen Dicke einer einzelnen Keramikschicht ein zur Ansteuerung erforderliches elektrisches Feld zu erzeugen. Diese Spannung liegt, wie bereits erwähnt, bei einer Schichtdicke der Keramikschichten von 20 bis 40 µm etwa bei 20 bis 80 Volt.

In vorteilhafter Ausgestaltung der Erfindung sind die Elektroden der ersten und der zweiten Gruppe eines Stapels über jeweils eine erste bzw. jeweils eine zweite Randelektrode miteinander elektrisch kontaktiert, wobei die erste und die zweite Randelektrode an gegenüberliegenden Seitenflächen des jeweiligen Stapels angeordnet sind und wobei die Elektroden der ersten und der zweiten Gruppe jeweils von der zweiten bzw. der ersten Randelektrode elektrisch isoliert sind. Die Elektroden eines derartigen Stapels erscheinen bei einem Querschnitt quer zur Stapelrichtung wie zwei ineinander eingreifende Kämme. Besonders von Vorteil ist es dabei, wenn die piezoelektrischen Keramikschichten eines Stapels in einer ungeraden Anzahl vorliegen. Auf diese Weise gehören nämlich die beiden außenliegenden Elektroden des Stapels zwei unterschiedlichen Gruppen an, so daß sich ein derartiger Stapel aus piezoelektrischen Keramikschichten durch Anlegen einer Spannung an die äußeren Elektroden in gleicher Weise aktivieren läßt wie eine ebenfalls mit äußeren Elektroden beaufschlagte einheitliche Piezokeramik gleicher Dicke. Allerdings beträgt die benötigte Betriebsspannung zur Aktivierung der einheitlichen Piezokeramik ein Vielfaches gegenüber der zur Aktivierung des Stapels notwendigen Betriebsspannung.

Zur Kontaktierung des derartigen piezoelektrischen Elements, wobei die Stapel jeweils aus einer ungeraden Anzahl von piezoelektrischen Keramikschichten aufgebaut sind und wobei die Elektroden in besagter Weise zusammengefaßt sind, sind zweckmäßigerweise drei elektrische Kontakte vorgesehen. Dabei weist die äußere Elektrode des ersten Stapels einen ersten, die äußere Elektrode des zweiten Stapels einen zweiten und die beiden inneren, direkt auf dem Tragkörper aufliegenden Elektroden des ersten bzw. des zweiten Stapels einen gemeinsamen dritten Kontakt auf. Dieser gemeinsame dritte Kontakt kann beispielsweise auf dem Tragkörper selbst angeordnet sein, falls dieser elektrisch leitend ist. Ansonsten kann der Tragkörper mit einer leitfähigen Belegung versehen werden. Zum Anschluß an eine Spannungsquelle werden entsprechende Verbindungskabel einfach über die Kontakte mit dem piezoelektrischen Element verbunden. Hierzu können die Kontakte beispielsweise aus einem lötfähigen Material bestehen.

Zur Ansteuerung werden nun der erste und der zweite Kontakt mit den entgegengesetzten Polen einer Gleichspannungsquelle verbunden. Der den inneren Elektroden gemeinsame Kontakt wird nun über eine steuerbare Spannungsquelle abwechselnd einmal mit dem einen und einmal mit dem anderen Potential der beiden Pole beaufschlagt. Dabei ist insbesondere beim Anschluß des ersten und des zweiten Kontakts darauf zu achten, daß das sich ausbildende elektrische Feld innerhalb jeder einzelnen piezoelektrischen Keramikschicht in Polarisationsrichtung zeigt. Bei einer derartigen Ansteuerung wird jeweils nur ein Stapel mit einer Spannung beaufschlagt und dadurch aktiviert. Der jeweils andere Stapel bleibt inaktiv. Entsprechend der an dem dritten Kontakt angelegten Spannung tritt eine Verbiegung des piezoelektrischen Elements einmal in die eine und einmal in die andere Richtung auf. Dabei sieht jede einzelne piezoelektrische Keramikschicht bei Aktivierung stets ein elektrisches Feld in Richtung der jeweiligen Polarisation. Auf diese Weise wird eine Deaktivierung des piezoelektrischen Elements sicher vermieden.

Für eine besonders gute Umsetzung von elektrischer in mechanischer Energie ist es vorteilhaft, wenn die Fläche des Tragkörpers größer ist als die Auflagefläche der Stapel, so daß sich ein freier Teil der Tragkörpers über die Stapel hinaus erstreckt. Auf diese Weise kann über die Hebelwirkung des Tragkörpers der Stell- oder Auslenkweg des piezoelektrischen Elements vergrößert werden.

Der dritte Kontakt zur gemeinsamen Kontaktierung der inneren Elektroden des ersten bzw. des zweiten Stapels erfolgt vorteilhafterweise über eine zumindest teilweise auf das freie Teil des Tragkörpers aufgebrachte Metallfolie, insbesondere eine Kupferfolie, welche sich zum Aufbringen eines Lötkontaktes eignet. Dabei kann die Metallfolie entweder im Falle eines leitfähigen oder im Falle eines mit einer leitfähigen Belegung versehenen elektrisch isolierenden Tragkörpers ausschließlich auf dem freien Teil des Tragkörpers aufgebracht oder im Falle eines elektrisch isolierenden Tragkörpers teilweise zwischen den Tragkörper und die jeweils innere Elektrode der Stapel eingelegt sein.

Ein Ausführungsbeispiel der Erfindung wird anhand einer Zeichnung näher erläutert. Dabei zeigen:
- FIG 1: einen Querschnitt durch ein als Biegewandler ausgebildetes, multimorphes, piezoelektrisches Element mit einem Tragkörper und
- FIG 2: eine Ausschnittsvergrößerung aus einem Querschnitt gemäß FIG 1, wobei der Tragkörper mit einer leitfähigen Belegung versehen ist.

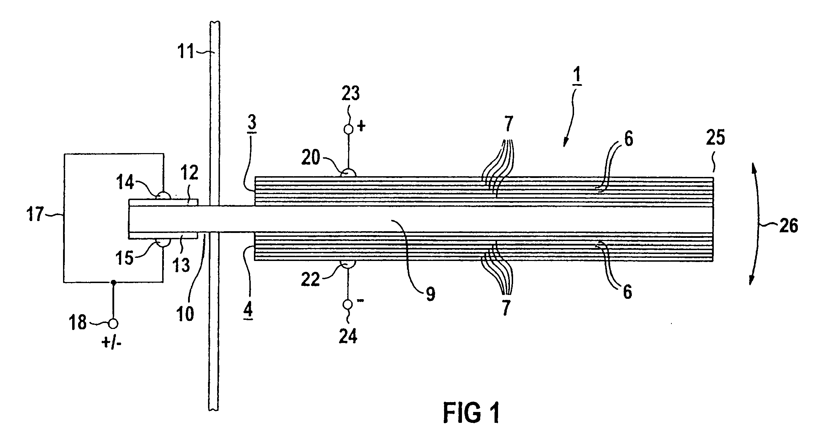

Figur 1 zeigt in einem Querschnitt ein als ein Biegewandler ausgebildetes piezoelektrisches Element 1 mit einem ersten Stapel 3 und einem zweiten Stapel 4, welche jeweils aus einer Anzahl von übereinandergestapelten Keramikschichten 6 mit dazwischen sowie an den begrenzenden Außenseiten angeordneten Elektroden 7 bestehen. Die beiden Stapel 3, 4 sind beidseitig auf einen Tragkörper 9 aufgebracht, welcher aus einem mit Kohlefaser verstärkten Epoxidharz besteht und folglich elektrisch leitend ist. Der Tragkörper 9 weist eine größere Fläche auf als die Auflagefläche der beiden Stapel 3, 4, so daß sich ein freier Teil 10 über die Stapel 3, 4 hinaus erstreckt. Der freie Teil 10 des Tragkörpers 9 ist in eine Halterung 11, welche hier nur schematisch gezeigt wird, eingespannt. Ebenso ist es möglich, den mit den Stapeln beaufschlagten Teil des Tragkörpers 9 in eine Halterung 11 einzuspannen.

Zur elektrischen Kontaktierung des piezoelektrischen Elements 1 sind auf das freie Ende 10 des Tragkörpers 9 beidseitig Kupferfolien 12, 13 aufgebracht. Dabei sind die Kupferfolien 12, 13 entweder auf den Tragkörper 9 aufgeklebt oder sind beim Aushärtevorgang des Epoxidharzes des Tragkörpers 9 mit diesem verbunden worden. Über die beiden Kupferfolien 12, 13 wird der Tragkörper 9 mit Hilfe der beiden Lötkontakte 14, 15 über den Anschlußdraht 17 mit einem auf positives und negatives Potential einer Gleichspannungsquelle schaltbaren Anschluß 18 verbunden. Des weiteren ist die äußere Elektrode des ersten Stapels 3 über einen Lötkontakt 20 an den Pluspol 23 der Gleichspannungsquelle angeschlossen. Die äußere Elektrode des zweiten Stapels 4 ist über den Lötkontakt 22 mit dem Minuspol 24 der Gleichspannungsquelle verbunden.

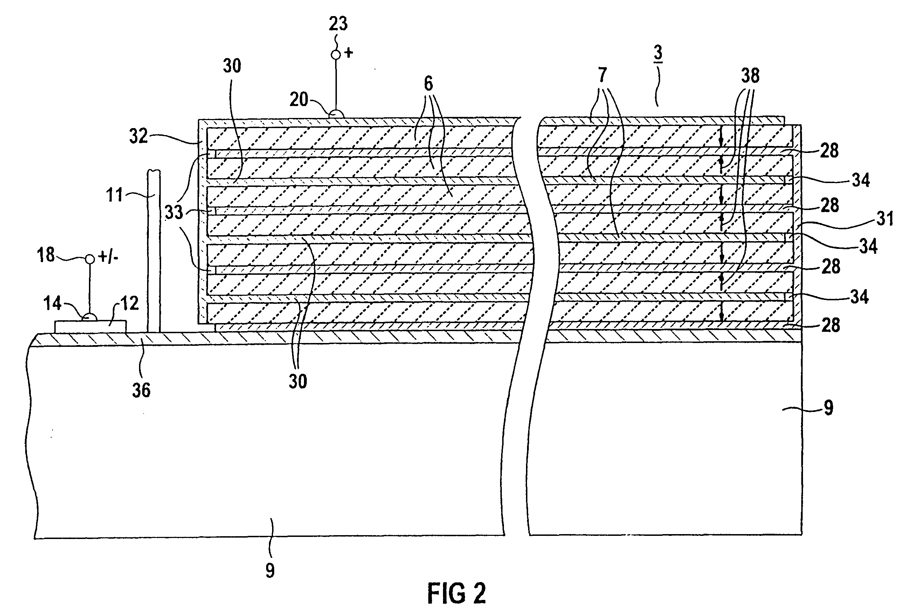

Gemäß der in Figur 2 näher gezeigten Anordnung der Elektroden 7 innerhalb der Stapel 3, 4 sind bei einer derartigen Beschaltung die Elektroden 7 entlang der Stapelrichtung alternierend einmal über die jeweilige äußere Elektrode mit dem Pluspol 23 bzw. dem Minuspol 24 und einmal über den Tragkörper 9 mit dem schaltbaren Anschluß 18 der Gleichspannungsquelle verbunden. Wird der schaltbare Anschluß 18 nun auf das Potential des Pluspols 23 gelegt, so wird in den Keramikschichten 6 des zweiten Stapels 4 ein elektrisches Feld erzeugt, wohingegen in den Keramikschichten 6 des ersten Stapels 3 kein elektrisches Feld aufgebaut wird. Mit der in Figur 2 näher gezeigten entgegengesetzten Polarisation aufeinander folgender Keramikschichten führt dies zu einer Kontraktion sämtlicher Keramikschichten 6 in dem zweiten Stapel 4; das freie Ende 25 des Biegewandlers bewegt sich entlang des eingezeichneten Pfeiles nach unten. Entsprechend bewegt sich das freie Ende 25 des piezoelektrischen Elements 1 entlang des eingezeichneten Pfeils nach oben, falls der schaltbare Anschluß 18 der Gleichspannungsquelle auf das Potential des Minuspols 24 gelegt wird.

Figur 2 zeigt in einer Ausschnittsvergrößerung detailliert den Aufbau des piezoelektrischen Elements 1 gemäß Figur 1. Dabei ist jedoch der Tragkörper 9 nicht, wie in Figur 1 dargestellt, aus einem Kohlefaser-verstärkten, sondern aus einem Glasfaser-verstärkten Epoxidharz und folglich elektrisch nicht-leitend. Aus Gründen der Übersichtlichkeit ist der zweite Stapel 4 in Figur 2 nicht eingezeichnet. Dieser ist jedoch in gleicher Weise ausgestaltet wie der dargestellte erste Stapel 3.

Bei dem dargestellten piezoelektrischen Element 1 gemäß Figur 2 sind die Elektroden 7 des Stapels 3 und in gleicher Weise die Elektroden des Stapels 4 in eine erste Gruppe 28 und in eine zweite Gruppe 30 von jeweils elektrisch in Verbindung stehenden Elektroden aufgeteilt. Die Elektroden der ersten Gruppe 28 sind dabei mittels einer an einem Ende des Stapels 3 angeordneten ersten Randelektrode 31 und die Elektroden der zweiten Gruppe 30 über eine am entgegengesetzten Ende des Stapels 3 angeordneten zweiten Randelektrode 32 jeweils elektrisch miteinander verbunden. Die beiden Randelektroden 31, 32 sind dabei in Form einer Metallisierung auf den Enden des Stapels 3 und des nicht dargestellten Stapels 4 aufgebracht. Die Elektroden der ersten Gruppe 28 sind von der zweiten Randelektrode 32 dadurch elektrisch isoliert, daß ihre Länge gegenüber der Länge des Stapels 3 verkürzt ist, so daß zwischen der zweiten Randelektrode 32 und den Elektroden der ersten Gruppe 28 jeweils ein Spalt 33 entsteht. Gleiches gilt für die Elektroden der zweiten Gruppe 30, wobei zwischen der ersten Randelektrode 31 und den Elektroden der zweiten Gruppe 30 jeweils ein Spalt 34 entsteht. Zwischen den Elektroden 7 sind jeweils Keramikschichten 6 angeordnet, wobei jeweils benachbarte Keramikschichten 6 eine entgegengesetzte Polarisation gemäß der in Figur 2 dargestellten Pfeile aufweisen. Jeder der Stapel 3, 4 weist eine ungerade Anzahl von Keramikschichten 6 auf. Im gezeigten Fall umfaßt jeder Stapel sieben Keramikschichten.

Die in der gezeigten Art und Weise aufgebauten Stapel 3, 4 aus aufeinanderfolgenden piezoelektrischen Keramikschichten lassen sich in der gleichen Art und Weise ansteuern wie eine einzelne zusammenhängende piezoelektrische Keramikschicht mit außenliegenden Elektroden. Werden nämlich die beiden äußeren Elektroden eines Stapels 3, 4 mit einer Spannung beaufschlagt, so wird in jeder einzelnen Keramikschicht 6 ein elektrisches Feld erzeugt, wobei die elektrischen Felder benachbarter Keramikschichten jeweils in entgegengesetzte Richtung zeigen. Da auch die Polarisationsrichtungen benachbarter Keramikschichten in entgegengesetzte Richtung zeigen, wird jede einzelne der Keramikschichten 6 eines Stapels in gleicher Weise angesteuert. Dabei zeigt jeweils das elektrische Feld in die gleiche Richtung wie die Polarisation.

Für das in Figur 2 dargestellte piezoelektrische Element 1 wird die Kontaktierung der inneren, dem Tragkörper 9 zugewandten Elektrode des ersten Stapels 3 (gleiches gilt natürlich für den nicht dargestellten zweiten Stapel 4) über eine zusätzlich auf den Tragkörper 9 aufgelegte leitfähige Belegung 36 sichergestellt. Auf diese leitfähige Belegung 36 ist am freien Teil 10 des Tragkörpers 9 eine Kupferfolie 12 aufgelegt, welche über den Lötkontakt 14 mit dem schaltbaren Anschluß 18 der Gleichspannungsquelle verbunden ist.

Wird der schaltbare Anschluß 18 der Gleichspannungsquelle mit dem Potential des Minuspols beaufschlagt, so sind sämtliche Elektroden der ersten Gruppe 28 mit dem Minuspol kontaktiert. Die Elektroden der zweiten Gruppe 30 hingegen sind über die äußere Elektrode mittels des Lötkontakts 20 mit dem Pluspol 23 der Gleichspannungsquelle verbunden. Auf diese Weise wird in jeder Keramikschicht 6 ein elektrisches Feld in der gleichen Richtung wie die jeweilige Polarisation (siehe eingezeichnete Pfeile) erzeugt. Entsprechend kontrahieren alle Keramikschichten 6 des ersten Stapels 3 senkrecht zur Richtung des elektrischen Feldes, d.h. der erste Stapel 3 verkürzt sich entlang der Richtung des Tragkörpers 9. Der Tragkörper 9 biegt sich folglich nach oben.

## Patentansprüche

1. Piezoelektrisches Element (1) mit einem ersten (3) und einem zweiten Stapel (4) aus einer Mehrzahl von piezoelektrischen Keramikschichten (6) und mit einer zwischen dem ersten (3) und dem zweiten Stapel (4) angeordneten Zwischenschicht, wobei in jedem Stapel (3, 4) zwischen den jeweiligen Keramikschichten (6) und an der jeweiligen Außenseite der den Stapel (3, 4) begrenzenden Keramikschichten (6) Elektroden (7) angeordnet sind, und wobei sich das Material der Zwischenschicht von dem Material der Keramikschichten (6) unterscheidet,
**dadurch gekennzeichnet, daß** die Zwischenschicht als ein Tragkörper (9) aus einem Faserverbundwerkstoff oder aus Glas ausgebildet ist.

2. Piezoelektrisches Element (1) nach Anspruch 1,
**dadurch gekennzeichnet, daß** die Dicke des Tragkörpers (9) größer ist als die Dicke einer einzelnen Keramikschicht (6).

3. Piezoelektrisches Element (1) nach Anspruch 2,
**dadurch gekennzeichnet, daß** der Faserverbundwerkstoff ein mit Kohle- oder Glasfaser verstärktes Epoxidharz ist.

4. Piezoelektrisches Element (1) nach einem der vorhergehenden Ansprüche,
**dadurch gekennzeichnet, daß** die Dicke der Keramikschichten (6) jeweils zwischen 20 und 40 µm und die Dicke des Tragkörpers (9) zwischen 100 und 1000 µm liegt.

5. Piezoelektrisches Element (1) nach einem der vorhergehenden Ansprüche,
**dadurch gekennzeichnet, daß** die Elektroden (7) jeden Stapels (3, 4) jeweils derart in eine erste (28) und in eine zweite Gruppe (30) elektrisch verbundener Elektroden (7) aufgeteilt sind, daß benachbarte Elektroden (7) jeweils der anderen Gruppe zugeordnet sind, und daß benachbarte Keramikschichten (6) jeweils entgegengesetzte Polarisationsrichtungen (38) parallel zur Stapelrichtung aufweisen.

6. Piezoelektrisches Element (1) nach Anspruch 5,
**dadurch gekennzeichnet, daß** die Elektroden (7) der ersten (28) und der zweiten Gruppe (30) eines Stapels (3, 4) über jeweils eine erste (31) bzw. jeweils eine zweite Randelektrode (32) miteinander elektrisch kontaktiert sind, wobei die erste (31) und die zweite Randelektrode (32) an gegenüberliegenden Seitenflächen des jeweiligen Stapels (3, 4) angeordnet sind und wobei die Elektroden (7) der ersten (28) und der zweiten Gruppe (30) jeweils von der zweiten (32) bzw. der ersten Randelektrode (31) elektrisch isoliert sind.

7. Piezoelektrisches Element (1) nach Anspruch 6,
**dadurch gekennzeichnet, daß** die Elektroden (7) der ersten (28) und der zweiten Gruppe (30) eines Stapels (3, 4) zur elektrischen Isolierung in Richtung zur zweiten (32) bzw. zur ersten Randelektrode (31) hin verkürzt sind.

8. Piezoelektrisches Element (1) nach einem der Ansprüche 5 bis 7,
**dadurch gekennzeichnet, daß** jeder Stapel (3, 4) eine ungerade Anzahl von Keramikschichten (6) umfaßt, und daß an der auf der Außenseite des ersten Stapels (3) angeordneten Elektrode ein erster (20), an der auf der Außenseite des zweiten Stapels (4) angeordneten Elektrode ein zweiter (22) und an den dem Tragkörper (9) direkt aufliegenden Elektroden ein gemeinsamer dritter elektrischer Kontakt (14, 15) angeordnet sind, wobei der erste (20) und der zweite Kontakt (22) jeweils zur elektrischen Kontaktierung der zweiten Gruppe (30) von Elektroden und der dritte Kontakt (14, 15) zur elektrischen Kontaktierung der ersten Gruppe (28) von Elektroden vorgesehen sind.

9. Piezoelektrisches Element (1) nach einem der vorhergehenden Ansprüche,
**dadurch gekennzeichnet, daß** die Fläche des Tragkörpers (9) größer ist als die Auflagefläche der Stapel (3, 4), so daß sich ein freier Teil (10) des Tragkörpers (9) über die Stapel (3, 4) hinaus erstreckt.

10. Piezoelektrisches Element (1) nach Anspruch 9,
**dadurch gekennzeichnet, daß** die Kontaktierung der zwischen Tragkörper (9) und Stapel (3, 4) angeordneten Elektroden über eine zumindest teilweise auf das freie Teil (10) des Tragkörpers (9) aufgebrachte Metallfolie, insbesondere eine Kupferfolie (12, 13), erfolgt, welche sich zum Aufbringen eines Lötkontakts (14, 15) eignet.

## Claims

1. Piezoelectric element (1) having a first (3) and a second stack (4) comprising a plurality of piezoelectric ceramic layers (6) and having an intermediate layer disposed between the first (3) and the second stack (4), electrodes (7) being disposed in each stack (3, 4) between the respective ceramic layers (6) and on the respective outer side of the ceramic layers (6) bounding the stack (3, 4), and the material of the intermediate layer differing from the material of the ceramic layers (6), **characterized in that** the intermediate layer is formed as a supporting body (9) made of a fibre composite material or glass.

2. Piezoelectric element (1) according to Claim 1, **characterized in that** the thickness of the supporting body (9) is greater than the thickness of an individual ceramic layer (6).

3. Piezoelectric element (1) according to Claim 2, **characterized in that** the fibre composite material is an epoxy resin reinforced with carbon or glass fibre.

4. Piezoelectric element (1) according to one of the preceding claims, **characterized in that** the thickness of the ceramic layers (6) is in each case between 20 and 40 µm, and the thickness of the supporting body (9) is between 100 and 1000 µm.

5. Piezoelectric element (1) according to one of the preceding claims, **characterized in that** the electrodes (7) of each stack (3, 4) are in each case subdivided into a first (28) and a second (30) group of electrically connected electrodes (7) in such a way that adjacent electrodes (7) are each assigned to the other group, and that adjacent ceramic layers (6) each have opposed directions of polarization (38) parallel to the stack direction.

6. Piezoelectric element (1) according to Claim 5, **characterized in that** the electrodes (7) of the first (28) and the second (30) group of a stack (3, 4) have electrical contact made between them in each case by a first (31) and a second (32) edge electrode, the first (31) and the second (32) edge electrodes being disposed on opposite side faces of the respective stack (3, 4), and the electrodes (7) of the first (28) and the second group (30) in each case being electrically insulated from the second (32) and the first (31) edge electrode respectively.

7. Piezoelectric element (1) according to Claim 6, **characterized in that** the electrodes (7) of the first (28) and the second (30) group of a stack (3, 4) are shortened in the direction of the second (32) or first (31) edge electrode respectively, for the purpose of electrical insulation.

8. Piezoelectric element (1) according to one of Claims 5 to 7, **characterized in that** each stack (3, 4) comprises an odd number of ceramic layers (6), and **in that** a first electrical contact (20) is arranged on the first electrode disposed on the outer side of the first stack(3), a second electrical contact (22) is arranged on the electrode disposed on the outer side of the second stack (4), and a common third electrical contact (14, 15) is arranged on the electrodes resting directly on the supporting body (9), the first (20) and the second (22) contact being provided in each case to make electrical contact with the second group (30) of electrodes, and the third contact (14, 15) being provided to make electrical contact with the first group (28) of electrodes.

9. Piezoelectric element (1) according to one of the preceding claims, **characterized in that** the area of the supporting body (9) is greater than the contact area of the stacks (3, 4), so that a free part (10) of the supporting body (9) extends beyond the stacks (3, 4).

10. Piezoelectric element (1) according to Claim 9, **characterized in that** contact is made with the electrodes disposed between the supporting body (9) and stacks (3, 4) via a metal foil, in particular a copper foil (12, 13), which is at least partly applied to the free part (10) of the supporting body (9) and which is suitable to have a solder contact (14, 15) fitted.

## Revendications

1. Elément piézoélectrique (1) comprenant un premier (3) et un deuxième empilement (4) d'une pluralité de couches de céramique piézoélectrique (6), et comprenant également une couche intermédiaire agencée entre le premier (3) et le deuxième empilement (4), des électrodes (7) étant agencées dans chaque empilement (3, 4) entre les couches de céramique (6) respectives et sur le côté extérieur respectif des couches de céramique (6) délimitant l'empilement (3, 4), et le matériau de la couche intermédiaire étant différent du matériau des couches de céramique (6),
**caractérisé en ce que** la couche intermédiaire est conçue sous la forme d'un corps de support (9) et est réalisée en un matériau composite de fibres ou en verre.

2. Elément piézoélectrique (1) selon la revendication 1,
**caractérisé en ce que** l'épaisseur du corps de support (9) est plus grande que l'épaisseur d'une couche de céramique (6) individuelle.

3. Elément piézoélectrique (1) selon la revendication 2,
**caractérisé en ce que** le matériau composite de fibres est une résine époxy renforcée de fibres de carbone ou de fibres de verre.

4. Elément piézoélectrique (1) selon l'une des revendications précédentes,
**caractérisé en ce que** l'épaisseur des couches de céramique (6) se situe respectivement entre 20 et 40 µm, et l'épaisseur du corps de support (9) entre 100 et 1000 µm.

5. Elément piézoélectrique (1) selon l'une des revendications précédentes,
**caractérisé en ce que** les électrodes (7) de chaque empilement (3, 4) sont respectivement subdivisées en un premier (28) et un deuxième groupe (30) d'électrodes (7) reliées électriquement, de façon telle que des électrodes (7) voisines sont respectivement associées à l'autre groupe, et **en ce que** des couches de céramique (6) voisines présentent des directions de polarisation (38) respectivement opposées, parallèlement à la direction d'empilement.

6. Elément piézoélectrique (1) selon la revendication 5, **caractérisé en ce que** les électrodes (7) du premier (28) et du deuxième groupe (30) d'un empilement (3, 4) sont contactées mutuellement sur le plan électrique par l'intermédiaire respectivement d'une première (31) et d'une deuxième électrode de bordure (32), la première (31) et la deuxième électrode de bordure (32) étant agencées sur des surfaces latérales opposées de l'empilement (3, 4) respectif, et les électrodes (7) du premier (28) et du deuxième groupe (30) étant isolées électriquement respectivement de la deuxième (32) et de la première électrode de bordure (31).

7. Elément piézoélectrique (1) selon la revendication 6, **caractérisé en ce que** les électrodes (7) du premier (28) et du deuxième groupe (30) d'un empilement (3, 4) sont, pour leur isolation électrique, raccourcies en direction respectivement de la deuxième (32) et de la première électrode de bordure (31).

8. Elément piézoélectrique (1) selon l'une des revendications 5 à 7,
**caractérisé en ce que** chaque empilement (3, 4) comprend un nombre impair de couches de céramique (6) et **en ce que** sur l'électrode agencée sur le côté extérieur du premier empilement (3) est disposé un premier contact électrique (20), sur l'électrode agencée sur le côté extérieur du deuxième empilement (4) est disposé un deuxième contact électrique (22), et sur les électrodes reposant directement sur le corps de support (9) est disposé un troisième contact électrique commun (14, 15), le premier (20) et le deuxième contact (22) étant respectivement prévus pour contacter électriquement le deuxième groupe d'électrodes (30) et le troisième contact (14, 15) pour contacter électriquement le premier groupe d'électrodes (28).

9. Elément piézoélectrique (1) selon l'une des revendications précédentes,
**caractérisé en ce que** la surface du corps de support (9) est plus grande que la surface d'appui des empilements (3, 4), de sorte qu'une partie libre (10) du corps de support (9) s'étend par-delà les empilements (3, 4) vers l'extérieur.

10. Elément piézoélectrique (1) selon la revendication 9,
**caractérisé en ce que** l'établissement du contact électrique des électrodes agencées entre le corps de support (9) et les empilements (3, 4) s'effectue par l'intermédiaire d'une feuille métallique, notamment une feuille de cuivre (12, 13) appliquée au moins partiellement sur la partie libre (10) du corps de support (9), cette feuille étant adaptée à l'application d'un contact de soudure (14, 15).
